# EUROPEAN PATENT APPLICATION

(11) **EP 4 440 056 A1**
(43) Date of publication of application: **02.10.2024**
(21) Application number: 22900288.6
(22) Date of filing: 17.11.2022
(51) Int. Cl.: H04L 25/03

(54) **SIGNAL RECEIVING METHOD AND APPARATUS, AND ELECTRONIC DEVICE AND STORAGE MEDIUM**

(30) Priority: 01.12.2021 CN 202111452557
(71) Applicant: ZTE Corporation, Shenzhen, Guangdong 518057 (CN)
(72) Inventor: QI, Nan, Shenzhen, Guangdong 518057 (CN); LI, Leliang, Shenzhen, Guangdong 518057 (CN); TANG, Ningfeng, Shenzhen, Guangdong 518057 (CN); LIU, Liyuan, Shenzhen, Guangdong 518057 (CN); WU, Nanjian, Shenzhen, Guangdong 518057 (CN); LIU, Jian, Shenzhen, Guangdong 518057 (CN); DUAN, Minghui, Shenzhen, Guangdong 518057 (CN); SHANG, Yingchun, Shenzhen, Guangdong 518057 (CN); CHEN, Xun, Shenzhen, Guangdong 518057 (CN); GAO, Yuqi, Shenzhen, Guangdong 518057 (CN)
(74) Representative: Bals & Vogel Patentanwälte PartGmbB
(86) International application number: PCT/CN2022/132573
(87) International publication number: WO 2023/098483

(57) **Abstract**

Disclosed in embodiments of the present application are a signal receiving method and apparatus, an electronic device and a storage medium. In the present application, the signa receiving method is applied to a pulse amplitude modulation 4 (AM4) signal receiver and comprises: receiving an input signal, and performing compensation equalization on the input signal (101); performing digital signal conversion on the input signal subjected to the compensation equalization, and performing delay detection on a digital signal conversion process (102); and according to a delay detection result, adaptively adjusting a compensation equalization process, and/or adaptively adjusting the digital signal conversion process (103).

## Description

### CROSS-REFERENCE TO RELATED APPLICATION

This application is filed on the basis of Chinese patent application No. 202111452557.5 filed December 01, 2021, and claims priority to the Chinese patent application, the entire contents of which are incorporated herein by reference.

### TECHNICAL FIELD

Embodiments of the present disclosure relate to the field of communications, and in particular, to a signal receiving method and apparatus, an electronic device, and a storage medium.

### BACKGROUND

Wired communication involves a transmitter that serializes data and drives a matching load or optical device, and a receiver that amplifies, equalizes, quantizes, and deserializes the received signal. With the rapid growth of data transmission bandwidth, the increase in channel loss makes the design of receivers more difficult. Stronger equalization techniques are required to compensate for channel loss to reduce the Bit Error Rate (BER). Wired communication has gradually developed from Pulse Amplitude Modulation 2 (PAM2) to Pulse Amplitude Modulation 4 (PAM4). Compared with a PAM2 signal, the hardware bandwidth required by a PAM4 signal is reduced by 50% provided that the same data bandwidth is achieved.

However, with the increase of input signal amplitudes, the receiver needs to perform compensation equalization and digital signal conversion on more signals with different amplitudes, making it more difficult to realize the adaptive adjustment of the compensation equalization process and the digital signal conversion process.

### SUMMARY

Embodiments of the present disclosure provide a signal receiving method and apparatus, an electronic device, and a storage medium.

An embodiment of the present disclosure provides a signal receiving method, applied to a PAM4 signal receiver, the signal receiving method includes: receiving an input signal, and performing compensation equalization on the input signal; performing digital signal conversion on the input signal subjected to the compensation equalization, and performing delay detection on the digital signal conversion process; and adaptively adjusting the compensation equalization process and/or adaptively adjusting the digital signal conversion process according to a result of the delay detection.

Another embodiment of the present disclosure provides a signal receiving apparatus, including: an equalization module, configured for receiving an input signal, and performing compensation equalization on the input signal; a delay module, configured for performing digital signal conversion on the input signal subjected to the compensation equalization, and performing delay detection on the digital signal conversion process; and an adjustment module, configured for adaptively adjusting the compensation equalization process and/or adaptively adjusting the digital signal conversion process according to a result of the delay detection.

Yet another embodiment of the present disclosure provides an electronic device, including: at least one processor; and a memory communicatively connected to the at least one processor, where the memory stores an instruction executable by the at least one processor which, when executed by the at least one processor, causes the at least one processor to implement the signal receiving method.

Yet another embodiment of the present disclosure provides a computer-readable storage medium, storing a computer program which, when executed by a processor, causes the processor to implement the signal receiving method.

### BRIEF DESCRIPTION OF DRAWINGS

FIG. 1 is a schematic flowchart of a signal receiving method according to an embodiment of the present disclosure;
FIG. 2 is a schematic structural diagram of a PAM4 receiver according to an embodiment of the present disclosure;
FIG. 3 is a schematic flowchart of adaptive adjustment according to an embodiment of the present disclosure;
FIG. 4 is a schematic structural diagram of a delay detector according to an embodiment of the present disclosure;
FIG. 5 is a schematic structural diagram of a threshold and equalization intensity logic circuit according to an embodiment of the present disclosure;
FIG. 6(a) is an eye pattern one of an output signal of a receiver sampler according to an embodiment of the present disclosure;
FIG. 6(b) is an eye pattern two of an output signal of a receiver sampler according to an embodiment of the present disclosure;
FIG. 6(c) is an eye pattern three of an output signal of a receiver sampler according to an embodiment of the present disclosure;
FIG. 6(d) is an eye pattern four of an output signal of a receiver sampler according to an embodiment of the present disclosure;
FIG. 7 is a schematic structural diagram of a signal receiving apparatus according to an embodiment of the present disclosure; and
FIG. 8 is a schematic structural diagram of an electronic device according to an embodiment of the present disclosure.

### DETAILED DESCRIPTION

To make the objectives, technical schemes and advantages of the embodiments of the present disclosure clear, the embodiments of the present disclosure will be described in detail below in conjunction with the drawings. However, it may be understood by those having ordinary skills in the art that although various embodiments of the present disclosure provide many technical details to make readers better understand the present disclosure, the technical schemes claimed in the present disclosure can be realized even without these technical details and various variations and modifications made based on the following embodiments. The following embodiments are divided for convenience of description and are not intended to constitute any limitation on the specific implementations of the present disclosure. The embodiments may be combined or used as references for each other if not in collision.

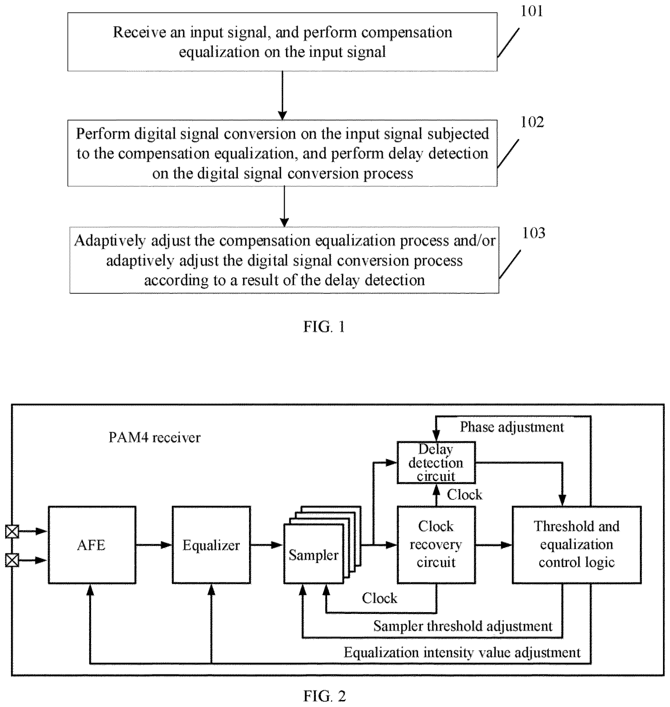

An embodiment of the present disclosure relates to a signal receiving method. As shown in FIG. 1, the method includes the following steps.

In a step of 101, an input signal is received, and compensation equalization is performed on the input signal.

In a step of 102, digital signal conversion is performed on the input signal subjected to the compensation equalization, and delay detection is performed on the digital signal conversion process.

In a step of 103, the compensation equalization process and/or the digital signal conversion process is adaptively adjusted according to a result of the delay detection.

The signal receiving method of this embodiment is applied to a PAM4 signal receiver. A modulation technique is a technique for converting a baseband signal (original electrical signal) into a signal to be transmitted. To ensure the communication effect and overcome the problems in long-distance signal transmission, the signal spectrum needs to be shifted through modulation to a high-frequency channel for transmission. PAM4 is one of Pulse Amplitude Modulation (PAM) techniques. PAM signal is a popular signal transmission technique after Non-Retum-to-Zero (NRZ). A NRZ signal uses high and low signal levels to represent 1 and 0 of a digital logic signal, so logic information of 1 bit can be transmitted in each clock cycle. A PAM4 signal is transmitted using four different signal levels, and logic information of 2 bits, namely, 00, 01, 10, and 11, can be transmitted in each clock cycle. Therefore, under the same baud rate condition, the bit rate of the PAM4 signal is twice that of the NRZ signal, such that the transmission efficiency is doubled, and the costs can be effectively reduced.

However, the PAM4 signal, though reducing the hardware bandwidth, increases the complexity of receiver design. To be specific, the number of comparators required for the receiver to quantize the input signal is changed from one to three. In addition, thresholds of the three comparators need to be optimized according to the amplitude of the input signal. A conventional threshold adjustment method requires an additional error sampler, and the thresholds of the comparators are optimized by comparing results of the sample comparators and the error sampler. However, such a method increases hardware costs and power consumption. Especially after the transmission rate is increased, the additional load increases the complexity in designing the Analog Front End (AFE).

As channel attenuation increases, a Decision Feedback Equalizer (DFE) is introduced into the receiver in addition to Continuous Time Linear Equalization (CTLE), to eliminate Inter Symbol Interference (ISI) caused by channel attenuation without amplifying noise, so as to reduce the BER. For different degrees of channel attenuation, the receiver cannot eliminate ISI using preset adjustment parameters. Therefore, the receiver needs to perform adaptive adjustment to eliminate ISI to the greatest extent. There are mainly three methods to implement adaptive adjustment. In a first method, an additional error sampler is provided, the equalization intensity and the comparator thresholds are adjusted, and convergence of the equalization intensity value is realized using a Least Mean Square error algorithm (LMS). In a second method, signal amplitude values of edge sampling points are minimized by adjusting the equalization intensity, to partially eliminate ISI. In a third method, the equalization intensity is adjusted to reduce the BER of the received signal to be small enough, so as to obtain an optimized equalization intensity. The first method requires additional hardware costs. The second method does not require additional hardware costs, but cannot completely eliminate ISI. The third method has satisfactory robustness, but requires additional hardware costs and a long adjustment time.

In the embodiments of the present disclosure, a technique for adaptive adjustment of a PAM4 receiver based on a delay of an output signal of a sampler of the PAM4 receiver is provided. The core of this technique is that the delay of the output signal obtained through quantization by the sampler varies significantly with input signals having different amplitudes. A high-speed PAM4 receiving method with an adaptive adjustment function is disclosed. In the embodiments of the present disclosure, the delay of the output signal obtained through quantization by the sampler varies significantly with input signals having different amplitudes, i.e., it can be determined according to delay information of the digital signal conversion whether the compensation equalization process and the digital signal conversion process deviate from a normal condition, and thus the compensation equalization process and the digital signal conversion process can be adaptively adjusted according to the delay. Therefore, an input signal is received, and compensation equalization is performed on the input signal; digital signal conversion is performed on the input signal subjected to the compensation equalization, and delay detection is performed on the digital signal conversion process; and the compensation equalization process and/or the digital signal conversion process is adaptively adjusted according to a result of the delay detection. In other words, it can be determined according to delay information of the digital signal conversion whether the compensation equalization process and the digital signal conversion process deviate from a normal condition and thus the compensation equalization process and the digital signal conversion process can be adaptively adjusted according to the delay. In this way, the signal receiver does not require an additional error sampler for the digital signal conversion process, and the adaptive adjustment of the signal receiver can be realized to obtain a more accurate signal reception result, thereby reducing hardware costs.

Implementation details of the signal receiving method of this embodiment will be described below and the following contents are provided only for convenience of understanding and are not necessary for implementing the present scheme.

In a step of 101, a PAM4 signal receiver receives an input signal, and performs compensation equalization on the input signal. The PAM4 signal receiver may use an analog front end and an equalizer to receive the input signal and perform compensation equalization on the input signal. The analog front end is configured for compensating for a bandwidth of the input signal and amplifying the input signal. The equalizer is configured for eliminating ISI of the input signal. When transmission of a high-rate signal is affected by channel attenuation, integrity of the signal will become worse. Therefore, an equalizer needs to be used to compensate for the signal to improve the signal quality. Because the signal loss is uncertain, it is necessary to adjust the equalization intensity to maximize the signal quality without over-compensation. To this end, an analog front end circuit is used for bandwidth compensation, i.e., the analog front-end circuit and the equalizer cooperate to implement optimal equalization to achieve optimal signal quality.

In a step of 102, the PAM4 signal receiver performs digital signal conversion on the input signal subjected to the compensation equalization, and performs delay detection on the digital signal conversion process. The delay is time required for the difference between the output level value of the sampler and the sampler threshold to reach a certain value, which may be set in advance by a technician. The PAM4 signal receiver may use a first sampler, a second sampler, and a delay detector to perform digital signal conversion and perform delay detection on the digital signal conversion process. The first sampler is configured for performing a first digital signal conversion of the input signal to obtain a first output level and a second output level. The second sampler is configured for performing a second digital signal conversion of the input signal to obtain a third output level and a fourth output level. The delay detector includes a first average delay comparator, a second average delay comparator, a first maximum delay comparator, and a second maximum delay comparator. The first average delay comparator is configured for acquiring a first average delay value of the first output level and a second average delay value of the second output level. The second average delay comparator is configured for acquiring a third average delay value of the third output level and a fourth average delay value of the fourth output level. The first maximum delay comparator is configured for acquiring a first maximum delay value of the first output level and a second maximum delay value of the second output level. The second maximum delay comparator is configured for acquiring a third maximum delay value of the third output level and a fourth maximum delay value of the fourth output level.

In an implementation, the delay detection includes average delay detection and maximum delay detection; and the PAM4 signal receiver adaptively adjusts the compensation equalization process and/or adaptively adjusts the digital signal conversion process according to a result of the average delay detection and a result of the maximum delay detection. In this way, the compensation equalization process and/or the digital signal conversion process is adaptively adjusted according to a result of the delay detection.

In this embodiment, the PAM4 signal receiver adaptively adjusts the compensation equalization process and/or adaptively adjusts the digital signal conversion process according to the result of the average delay detection and the result of the maximum delay detection, such that adaptive adjustment of the receiver can be realized to obtain a more accurate signal reception result.

In a step of 103, the PAM4 signal receiver adaptively adjusts the compensation equalization process and/or adaptively adjusts the digital signal conversion process according to a result of the delay detection. The PAM4 signal receiver may use a threshold and equalization control logic to adaptively adjust the analog front end and the equalizer and/or adaptively adjust the first sampler and the second sampler.

In an implementation, the PAM4 signal receiver respectively performs delay detection on four levels obtained through the digital signal conversion to obtain an average delay value and a maximum delay value of each level; adaptively adjusts an equalization intensity value of the compensation equalization process, such that after the adjustment, the average delay value of each level and the maximum delay value of the four levels are reduced, so that the compensation equalization process can be adaptively adjusted; and adaptively adjusts a sampler threshold in the digital signal conversion process, such that after the adjustment, a difference between the average delay values of every two of the levels is reduced, so that the compensation equalization process and the digital signal conversion process can be adaptively adjusted.

For a certain sampler threshold voltage, a larger difference between the amplitude of the input signal and the threshold voltage indicates a smaller delay of the sampler output. Based on this, it can be determined whether the sampler threshold and the equalizer intensity deviate from optimal values respectively. An eye pattern of the PAM4 signal includes 4 levels and 3 eyes formed thereby. To enable the receiver to obtain an optimal BER, the thresholds of the samplers should be respectively in the middle of the three eyes. If the sampler threshold deviates from the middle of the eye, there is a difference between delays of sampler outputs corresponding to upper and lower levels of the eye corresponding to the sampler. The deviation of the threshold can be acquired by detecting this difference, and then the threshold can be adjusted to an optimal value.

In an implementation, when transmission of a high-rate signal is affected by channel attenuation, integrity of the signal is abruptly deteriorated, affecting the BER of the receiver. When the channel attenuation is very small, the eye pattern of the input of the receiver is of good quality, showing that the eye is very clearly open. In this case, the voltage value of each level in the PAM4 eye changes in a small range, and the delay of the sampler output corresponding to each level shows two characteristics: (1) the corresponding delay is very small because the difference between the level value and the threshold voltage is large; and (2) the variation of the corresponding delay is very small because the variation range of the voltage value of each level is very small. When the PAM4 eye pattern is closed due to signal deterioration, the signal deterioration status is acquired by detecting the delay information corresponding to the two levels and the equalization intensity of the receiver is adjusted, thereby optimizing the BER of the received signal of the receiver.

In this embodiment, by respectively performing delay detection on the four levels obtained through the digital signal conversion to obtain the average delay value and the maximum delay value of each level, the delay detection can be realized. By adaptively adjusting the equalization intensity value of the compensation equalization process, such that after the adjustment, the average delay value of each level and the maximum delay value of the four levels are reduced, and the compensation equalization process can be adaptively adjusted. By adaptively adjusting the sampler threshold in the digital signal conversion process, such that after the adjustment, a difference between the average delay values of every two of the levels is reduced, and the digital signal conversion process can be adaptively adjusted. In this way, adaptive adjustment of the signal receiver can be realized to obtain a more accurate signal reception result.

In an implementation, the PAM4 signal receiver may acquire the equalization intensity value obtained through historical adjustment; stop the adaptive adjustment of the equalization intensity value in case of convergence of a historical numerical sequence of the equalization intensity value; acquire the sampler threshold obtained through historical adjustment; and stop the adaptive adjustment of the sampler threshold in case of convergence of the historical numerical sequence of the sampler threshold.

In this embodiment, the equalization intensity value obtained through historical adjustment is acquired, and in case of convergence of the historical numerical sequence of the equalization intensity value, the adaptive adjustment of the equalization intensity value is stopped; and the sampler threshold obtained through historical adjustment is acquired, and in case of convergence of the historical numerical sequence of the sampler threshold, the adaptive adjustment of the sampler threshold is stopped. In other words, when the adjustment amount is very small, i.e., the adjustment result can meet the usage requirement, the adaptive adjustment of the compensation equalization process and the digital signal conversion process is stopped, to avoid infinite adjustment of the compensation equalization process and the digital signal conversion process, thereby saving computing resources in the adaptive adjustment process.

In an implementation, the PAM4 signal receiver is further provided with a phase controller configured for generating an average clock and a maximum clock according to a preset sampling clock. The average clock is configured for triggering the first average delay comparator and the second average delay comparator, and the maximum clock is configured for triggering the first maximum delay comparator and the second maximum delay comparator. The threshold and equalization control logic is further configured for adaptively adjusting the phase controller.

In this embodiment, the phase controller can generate the average clock and the maximum clock according to the preset sampling clock. The average clock is configured for triggering the first average delay comparator and the second average delay comparator. The maximum clock is configured for triggering the first maximum delay comparator and the second maximum delay comparator. The threshold and equalization control logic is further configured for adaptively adjusting the phase controller. In this way, the compensation equalization process and/or the digital signal conversion process can be further adjusted, to improve the precision of adaptive adjustment of the compensation equalization process and/or the digital signal conversion process.

In an implementation, as shown in FIG. 2, an input signal of a receiver is first subjected to channel attenuation compensation by an analog front end circuit and an equalizer. An analog signal obtained through the compensation is quantized into a 0/1 digital signal by a sampler and transmitted to a clock recovery circuit and a delay detection circuit. The clock recovery circuit adjusts a phase of a clock signal, where the adjusted clock signal is used as a working clock of the sampler and the delay detection circuit. The delay detection circuit processes an output of the sampler to acquire delay information. A threshold and equalization logic circuit analyzes and processes the delay information, and adjusts a clock phase of the delay detection circuit, a threshold of the sampler, and equalization intensities of the analog front end and the equalizer.

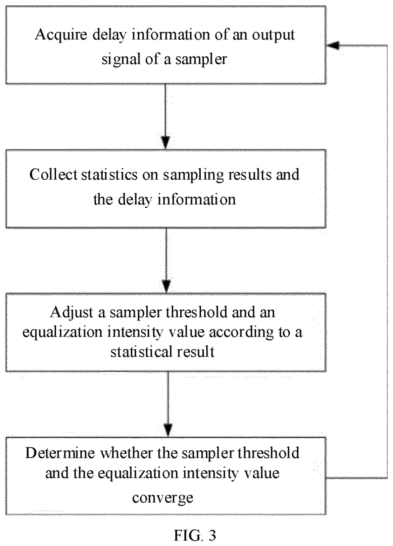

FIG. 3 is a flowchart of an adaptive adjustment process of the receiver. First, the delay detection circuit acquires the delay information of the output signal of the sampler. Next, the threshold and equalization logic circuit collects statistics on an output result of the sampler and an output result of the delay detection circuit. Then, the threshold of the sampler and the equalization intensity of the equalizer are adjusted according to a statistical result. Finally, convergence statuses of the threshold of the sampler and the equalization intensity of the equalizer are determined. If the threshold of the sampler and the equalization intensity of the equalizer converge, the adjustment is stopped; if the threshold of the sampler and the equalization intensity of the equalizer do not converge, the above process is performed cyclically.

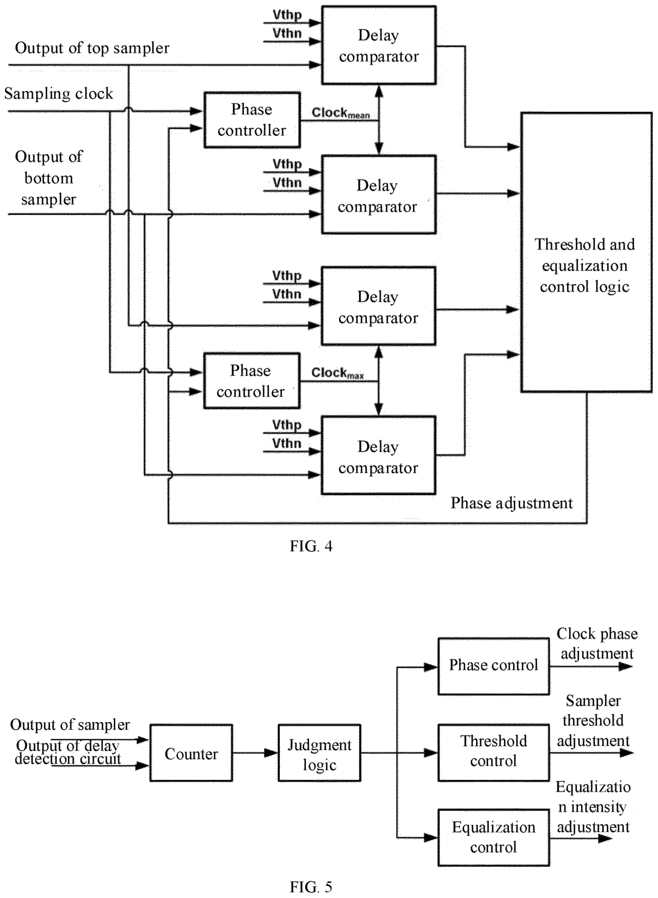

FIG. 4 is a schematic block diagram of the delay detection circuit. The delay detection circuit includes four delay comparators and two phase controllers. The delay comparator is triggered by a clock output by the phase controller to operate, to compare the output of the sampler with a preset comparator threshold and output a result of the comparison to the threshold and equalization logic circuit. The output of the sampler includes a top sampler and a bottom sampler in a PAM4 sampler. The sampling clock is controlled by the phase controller to generate an average clock (clockₘₑₐₙ) and a maximum clock (clockₘₐₓ). In the figure, Vthp and Vthn represent values of p and n ends of a differential input, i.e., an output value of the sampler and the sampler threshold.

FIG. 5 is a structural block diagram of the threshold and equalization logic circuit, mainly including a counter, a logic, phase adjustment, threshold adjustment, and an equalization control. The counter collects statistics on the outputs of the sampler and the delay detector. The logic makes a decision on the statistical result, and generates control signals for the phase control, the threshold control, and the equalization control. These control modules finally adjust corresponding circuit parameters.

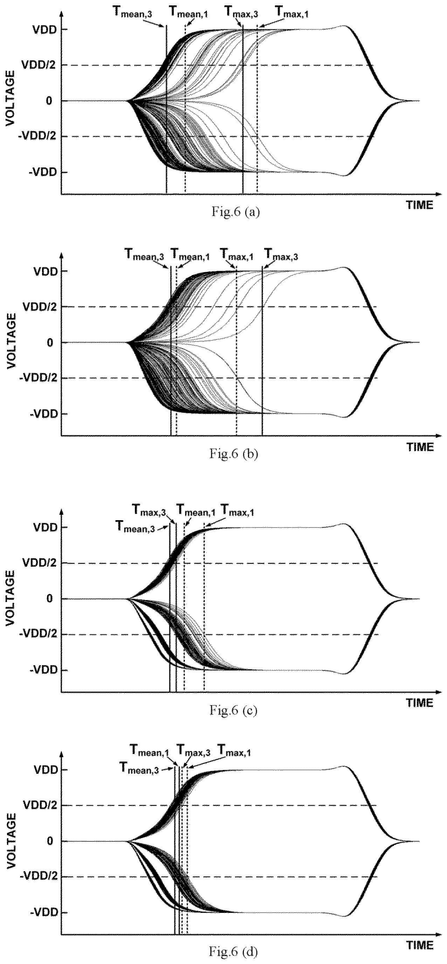

FIG. 6(a) to FIG. 6(d) show sampler outputs at different sampler thresholds and equalization intensity states of the equalizer. The top sampler is used as an example for description, where T_{mean,3} and T_{mean,1} respectively represent an average sampler output delay of a level of 3 and an average sampler output delay of a level of 1 in a PAM4 signal (which has four levels: 3, 1, -1, and -3), and T_{max,3} and T_{max,1} respectively represent a maximum sampler output delay of the level of 3 and a maximum sampler output delay of the level of 1 in the PAM4 signal. FIG. 5(a) shows an eye pattern of the sampler output before the sampler threshold and the equalization intensity are optimized. In this case, T_{mean,3} and T_{mean,1} differ greatly, and T_{mean,3} and T_{max,3} as well as T_{mean,1} and T_{max,1} are respectively significantly different. For example, the delay difference reaches 1/4 of a clock cycle or half a clock cycle. This indicates that the sampler threshold deviates from the central position of the eye, and the eye pattern is of low quality and is not fully open. FIG. 5(b) shows an eye pattern of the sampler output after the sampler threshold is optimized and before the equalization intensity is optimized. In this case, T_{mean,3} and T_{mean,1} differ slightly, and T_{mean,3} and T_{max,3} as well as T_{mean,1} and T_{max,1} are respectively significantly different. This indicates that the sampler threshold is at the central position of the eye, but the eye pattern is of low quality and is not fully open. FIG. 5(c) shows an eye pattern of the sampler output before the sampler threshold is optimized and after the equalization intensity is optimized. FIG. 5(d) shows an eye pattern of the sampler output after both the sampler threshold and the equalization intensity are optimized.

In this embodiment, with the use of the delay information of the output of the data sampler, there is no need to provide an additional error sampler, thereby reducing hardware costs. With the use of the delay detector, the adaptive adjustment of the threshold and the equalization intensity can be realized at the same time for signals with different input amplitudes and different channel losses. The threshold and equalization intensity logic circuit operates in real time and has a high update rate, thereby reducing the time consumption of the adaptive adjustment.

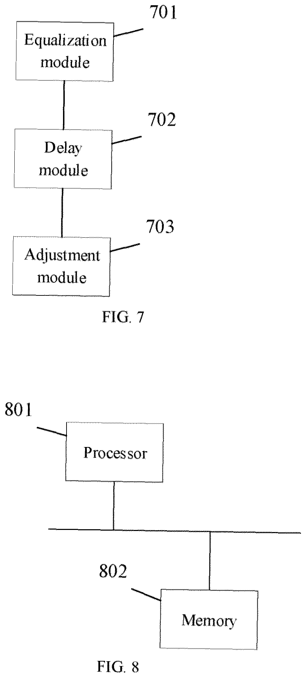

An embodiment of the present disclosure relates to a signal receiving apparatus. As shown in FIG. 7, the apparatus includes:
an equalization module 701, configured for receiving an input signal, and performing compensation equalization on the input signal;
a delay module 702, configured for performing digital signal conversion on the input signal subjected to the compensation equalization, and performing delay detection on the digital signal conversion process; and
an adjustment module 703, configured for adaptively adjusting the compensation equalization process and/or adaptively adjusting the digital signal conversion process according to a result of the delay detection.

In an implementation, the delay detection includes average delay detection and maximum delay detection; and adaptively adjusting the compensation equalization process and/or adaptively adjusting the digital signal conversion process according to a result of the delay detection includes: adaptively adjusting the compensation equalization process and/or adaptively adjusting the digital signal conversion process according to a result of the average delay detection and a result of the maximum delay detection.

In an implementation, performing delay detection on the digital signal conversion process includes: respectively performing delay detection on four levels obtained through the digital signal conversion to obtain an average delay value and a maximum delay value of each level; adaptively adjusting the compensation equalization process includes: adaptively adjusting an equalization intensity value of the compensation equalization process, such that after the adjustment, the average delay value of each level and the maximum delay value of the four levels are reduced; and adaptively adjusting the digital signal conversion process includes: adaptively adjusting a sampler threshold in the digital signal conversion process, such that after the adjustment, a difference between the average delay values of every two of the levels is reduced.

In an implementation, adaptively adjusting the compensation equalization process includes: acquiring the equalization intensity value obtained through historical adjustment; and stopping the adaptive adjustment of the equalization intensity value in case of convergence of a historical numerical sequence of the equalization intensity value; and adaptively adjusting a sampler threshold in the digital signal conversion process includes: acquiring the sampler threshold obtained through historical adjustment; and stopping the adaptive adjustment of the sampler threshold in case of convergence of the historical numerical sequence of the sampler threshold.

In an implementation, the equalization module includes an analog front end and an equalizer. The analog front end is configured for compensating for a bandwidth of the input signal and amplifying the input signal, and the equalizer is configured for eliminating ISI of the input signal. The delay module includes a first sampler, a second sampler, and a delay detector. The first sampler is configured for performing a first digital signal conversion of the input signal to obtain a first output level and a second output level, and the second sampler is configured for performing a second digital signal conversion of the input signal to obtain a third output level and a fourth output level. The delay detector includes a first average delay comparator, a second average delay comparator, a first maximum delay comparator, and a second maximum delay comparator. The first average delay comparator is configured for acquiring a first average delay value of the first output level and a second average delay value of the second output level. The second average delay comparator is configured for acquiring a third average delay value of the third output level and a fourth average delay value of the fourth output level. The first maximum delay comparator is configured for acquiring a first maximum delay value of the first output level and a second maximum delay value of the second output level. The second maximum delay comparator is configured for acquiring a third maximum delay value of the third output level and a fourth maximum delay value of the fourth output level. The adjustment module includes a threshold and equalization control logic. The threshold and equalization control logic is configured for adaptively adjusting the analog front end and the equalizer and/or adaptively adjusting the first sampler and the second sampler.

In an implementation, the delay module further includes a phase controller. The phase controller is configured for generating an average clock and a maximum clock according to a preset sampling clock. The average clock is configured for triggering the first average delay comparator and the second average delay comparator, and the maximum clock is configured for triggering the first maximum delay comparator and the second maximum delay comparator. The threshold and equalization control logic is further configured for adaptively adjusting the phase controller.

Because this embodiment corresponds to the foregoing embodiments, this embodiment may be implemented in combination with the foregoing embodiments. The related technical details mentioned in the foregoing embodiments are still valid in this embodiment, and the technical effects achieved in the foregoing embodiments can also be achieved in this embodiment. The details will not be repeated here in order to reduce repetition. Correspondingly, the related technical details mentioned in this embodiment are also applicable to the above embodiments.

An embodiment of the present disclosure relates to an electronic device. As shown in FIG. 8, the electronic device includes: at least one processor 801, and a memory 802 communicatively connected to the at least one processor. The memory 802 stores an instruction executable by the at least one processor 801 which, when executed by the at least one processor 801, causes the at least one processor 801 to implement the signal receiving method according to any one of the foregoing embodiments.

The memory 802 and the processor 801 are connected by a bus. The bus may include any number of interconnected buses and bridges. The bus connects various circuits of one or more processors 801 and the memory 802 together. The bus may also connect together a peripheral device, a voltage regulator, a power management circuit, and other circuits, which are well known in the art and therefore will not be detailed herein. A bus interface provides an interface between the bus and a transceiver. The transceiver may be one element or a plurality of elements, for example, a plurality of receivers and transmitters, and provides a unit for communicating with various other apparatus over a transmission medium. Information processed by the processor 801 is transmitted over a wireless medium through an antenna. In an implementation, the antenna further receives information and transmits the information to the processor 801.

The processor 801 is configured for managing the bus and general processing and may also provide various functions including timing, peripheral interfaces, voltage regulation, power management and other control functions. The memory 802 may be configured to store information used by the processor in performing operations.

An embodiment of the present disclosure relates to a computer-readable storage medium, storing a computer program which, when executed by a processor, causes the processor to implement the foregoing method embodiments.

It may be understood by those having ordinary skills in the art that all or some of the steps of the methods in the above embodiments may be performed by a program instructing related hardware. The program is stored in a storage medium, and includes several instructions to cause a device (which may be a single chip microcomputer, a chip, etc.) or a processor to perform all or some of the steps of the methods described in the embodiments of the present disclosure. The foregoing storage medium includes: any medium that can store program code, such as a Universal Serial Bus (USB) flash drive, a removable hard disk, a Read-Only Memory (ROM), a Random Access Memory (RAM), a magnetic disk, or an optical disk.

In the signal receiving method provided in the embodiments of the present disclosure, the delay of the output signal obtained through quantization by the sampler varies significantly with input signals having different amplitudes, i.e., it can be determined according to delay information of the digital signal conversion whether the compensation equalization process and the digital signal conversion process deviate a normal condition and the compensation equalization process and the digital signal conversion process can be adaptively adjusted according to the delay. Therefore, an input signal is received, and compensation equalization is performed on the input signal; digital signal conversion is performed on the input signal subjected to the compensation equalization, and delay detection is performed on the digital signal conversion process; and the compensation equalization process and/or the digital signal conversion process is adaptively adjusted according to a result of the delay detection. In other words, it can be determined according to delay information of the digital signal conversion whether the compensation equalization process and the digital signal conversion process deviate a normal condition and the compensation equalization process and the digital signal conversion process can be adaptively adjusted according to the delay. In this way, the signal receiver does not require an additional error sampler for the digital signal conversion process, and the adaptive adjustment of the signal receiver is realized to obtain a more accurate signal reception result, thereby reducing hardware costs.

## Claims

1. A signal receiving method, applied to a Pulse Amplitude Modulation 4, PAM4, signal receiver, the signal receiving method comprising:
receiving an input signal, and performing compensation equalization on the input signal;
performing digital signal conversion on the input signal subjected to the compensation equalization, and performing delay detection on the digital signal conversion process; and
adaptively adjusting the compensation equalization process and/or adaptively adjusting the digital signal conversion process according to a result of the delay detection.

2. The signal receiving method of claim 1, wherein the delay detection comprises average delay detection and maximum delay detection; and
adaptively adjusting the compensation equalization process and/or adaptively adjusting the digital signal conversion process according to a result of the delay detection comprises:
adaptively adjusting the compensation equalization process and/or adaptively adjusting the digital signal conversion process according to a result of the average delay detection and a result of the maximum delay detection.

3. The signal receiving method of claim 2, wherein performing delay detection on the digital signal conversion process comprises:
respectively performing delay detection on four levels obtained through the digital signal conversion to obtain an average delay value and a maximum delay value of each level;
adaptively adjusting the compensation equalization process comprises:
adaptively adjusting an equalization intensity value of the compensation equalization process, such that after the adjustment, the average delay value of each level and the maximum delay value of the four levels are reduced; and
adaptively adjusting the digital signal conversion process comprises:
adaptively adjusting a sampler threshold in the digital signal conversion process, such that after the adjustment, a difference between the average delay values of every two of the levels is reduced.

4. The signal receiving method of claim 3, wherein adaptively adjusting an equalization intensity value of the compensation equalization process comprises:
acquiring the equalization intensity value obtained through historical adjustment; and
stopping the adaptive adjustment of the equalization intensity value in response to convergence of a historical numerical sequence of the equalization intensity value; and
adaptively adjusting a sampler threshold in the digital signal conversion process comprises:
acquiring the sampler threshold obtained through historical adjustment; and
stopping the adaptive adjustment of the sampler threshold in response to convergence of the historical numerical sequence of the sampler threshold.

5. The signal receiving method of claim 3 or 4, wherein performing digital signal conversion on the input signal subjected to the compensation equalization, and performing delay detection on the digital signal conversion process comprises:
performing a first digital signal conversion of the input signal using a first sampler to obtain a first output level and a second output level, and performing a second digital signal conversion of the input signal using a second sampler to obtain a third output level and a fourth output level;
acquiring a first average delay value of the first output level and a second average delay value of the second output level using a first average delay comparator, and acquiring a first maximum delay value of the first output level and a second maximum delay value of the second output level using a first maximum delay comparator; and
acquiring a third average delay value of the third output level and a fourth average delay value of the fourth output level using a second average delay comparator, and acquiring a third maximum delay value of the third output level and a fourth maximum delay value of the fourth output level using a second maximum delay comparator.

6. A signal receiving apparatus, comprising:
an equalization module, configured for receiving an input signal, and performing compensation equalization on the input signal;
a delay module, configured for performing digital signal conversion on the input signal subjected to the compensation equalization, and performing delay detection on the digital signal conversion process; and
an adjustment module, configured for adaptively adjusting the compensation equalization process and/or adaptively adjusting the digital signal conversion process according to a result of the delay detection.

7. The signal receiving apparatus of claim 6, wherein,
the equalization module comprises an analog front end and an equalizer;
the analog front end is configured for compensating for a bandwidth of the input signal and amplifying the input signal;
the equalizer is configured for eliminating Inter-Symbol Interference (ISI) of the input signal;
the delay module comprises a first sampler, a second sampler, and a delay detector;
the first sampler is configured for performing a first digital signal conversion of the input signal to obtain a first output level and a second output level;
the second sampler is configured for performing a second digital signal conversion of the input signal to obtain a third output level and a fourth output level;
the delay detector comprises a first average delay comparator, a second average delay comparator, a first maximum delay comparator, and a second maximum delay comparator;
the first average delay comparator is configured for acquiring a first average delay value of the first output level and a second average delay value of the second output level;
the second average delay comparator is configured for acquiring a third average delay value of the third output level and a fourth average delay value of the fourth output level;
the first maximum delay comparator is configured for acquiring a first maximum delay value of the first output level and a second maximum delay value of the second output level;
the second maximum delay comparator is configured for acquiring a third maximum delay value of the third output level and a fourth maximum delay value of the fourth output level; and
the adjustment module comprises a threshold and equalization control logic; and
the threshold and equalization control logic is configured for adaptively adjusting the analog front end and the equalizer and/or adaptively adjusting the first sampler and the second sampler.

8. The signal receiving apparatus of claim 7, wherein the delay module further comprises a phase controller;
the phase controller is configured for generating an average clock and a maximum clock according to a preset sampling clock, wherein,
the average clock is configured for triggering the first average delay comparator and the second average delay comparator, and the maximum clock is configured for triggering the first maximum delay comparator and the second maximum delay comparator; and
the threshold and equalization control logic is further configured for adaptively adjusting the phase controller.

9. An electronic device, comprising:
at least one processor; and
a memory communicatively connected to the at least one processor,
wherein the memory stores an instruction executable by the at least one processor, which, when executed by the at least one processor, causes the at least one processor to perform the signal receiving method of any one of claims 1 to 5.

10. A computer-readable storage medium, storing a computer program which, when executed by a processor, causes the processor to perform the signal receiving method of any one of claims 1 to 5.
